# EUROPEAN PATENT APPLICATION

(11) **EP 4 621 430 A1**
(43) Date of publication of application: **24.09.2025**
(21) Application number: 24892490.4
(22) Date of filing: 13.08.2024
(51) Int. Cl.: G01R 31/396, G01N 27/00

(54) **BATTERY NICKEL TAB WELDING QUALITY TESTING SYSTEM AND BATTERY NICKEL TAB WELDING QUALITY TESTING METHOD**

(30) Priority: 02.02.2024 CN 202410146991
(71) Applicant: Contemporary Amperex Technology Co., Limited, Ningde, Fujian 352100 (CN)
(72) Inventor: ZHU, Zhiqin, Ningde, Fujian 352100 (CN); WANG, Jiacai, Ningde, Fujian 352100 (CN)
(74) Representative: Ran, Handong
(86) International application number: PCT/CN2024/111641
(87) International publication number: WO 2025/161339

(57) **Abstract**

The present application provides a battery nickel sheet welding quality detection system and a battery nickel sheet welding quality detection method. The system includes a transverse moving platform; a detection assembly, including: a support, capable of being movably disposed on the transverse moving platform along a first linear direction relative to the transverse moving platform; a probe plate; probe assemblies, each of the probe assemblies being disposed at a corresponding preset position of the probe plate and configured to be used for detecting relevant electrical parameters at a corresponding position of a battery to be detected, and including a probe base, a plurality of probes and plug-in electrical connectors, and an adjustment mechanism, the probe plate being disposed at the bottom end of the adjustment mechanism; a camera assembly, configured to acquire first image information of the battery to be detected; and a control apparatus, configured to control, according to the first image information, the adjustment mechanism to adjust the probe plate to a detection position, where the first linear direction is parallel to the plane where the probe plate is located. The system can effectively detect a battery product with a plurality of sets of battery cells arranged side by side, avoiding the need of manually adjusting the position of the battery.

## Description

### CROSS-REFERENCE

The present application refers to Chinese Patent Application No. 202410146991.8 entitled "BATTERY NICKEL SHEET WELDING QUALITY DETECTION SYSTEM AND BATTERY NICKEL SHEET WELDING QUALITY DETECTION METHOD", filed on February 2, 2024, which is incorporated herein by reference in its entirety.

### TECHNICAL FIELD

The present application relates to the technical field of battery manufacturing, and in particular, to a battery nickel sheet welding quality detection system and a battery nickel sheet welding quality detection method.

### BACKGROUND

Energy conservation and emission reduction are the key to sustainable development of the automobile industry. Electric vehicles have become an important part of the sustainable development of the automobile industry due to their energy-saving and environment-friendly advantages. For the electric vehicles, the battery technology is an important factor in their development.

Currently, nickel sheets are generally used in power batteries to lead out electrodes in battery cells. Therefore, the welding quality of the nickel sheets of the batteries needs to be detected before the batteries leave the factory, so as to prevent problems such as poor contact. The detection is mainly performed by a battery nickel sheet welding quality detection system, which generally includes a plurality of probe assemblies. Each of the probe assemblies is used for detecting electrical parameters (current, voltage, resistance, etc.) at a specific position of a battery nickel sheet, such that whether the nickel sheet at the position is normally welded can be determined by using the parameters. However, the current battery nickel sheet welding quality detection system has defects in design, and needs to be further improved to increase the efficiency and accuracy of the detection.

The methods described in this section are not necessarily methods that have been previously conceived or adopted. Unless otherwise indicated, it should not be assumed that any of the methods described in this section qualify as prior art merely by virtue of their inclusion in this section. Similarly, unless otherwise indicated, the problems mentioned in this section should not be considered as having been acknowledged in any prior art.

### SUMMARY

The battery nickel sheet welding quality detection system in the related art requires manual adjustment of the position of the battery, which increases the difficulty and complexity of the detection. The present application provides a battery nickel sheet welding quality detection system and a battery nickel sheet welding quality detection method. The battery nickel sheet welding quality detection system according to the embodiments of the present application can effectively detect a battery product with a plurality of sets of battery cells arranged side by side, avoiding the need of manually adjusting the position of the battery.

Embodiments of a first aspect of the present application provide a battery nickel sheet welding quality detection system, including: a transverse moving platform; and a detection assembly including: a support, capable of being movably disposed on the transverse moving platform along a first linear direction relative to the transverse moving platform; a probe plate, disposed on the support; and at least one probe assembly, each probe assembly disposed at a corresponding preset position of the probe plate and configured to detect relevant electrical parameters at a corresponding position of a battery to be detected, and any one of the at least one probe assembly including: a probe base including a plurality of probe insertion holes spaced apart from each other; a plurality of probes, each of the probes being disposed in a corresponding probe insertion hole, for detecting the relevant electrical parameters; and a first plug-in electrical connector, the first plug-in electrical connector being fixed to the probe base, one end of the first plug-in electrical connector being provided with a plurality of first electrical contacts, each of the plurality of first electrical contacts being electrically connected to a corresponding probe, and the other end of the first plug-in electrical connector being configured to be capable of mating with another electrical connector; and an adjustment mechanism, disposed on the support, the probe plate being disposed at the bottom end of the adjustment mechanism; a camera assembly, disposed on the adjustment mechanism and configured to acquire first image information of the battery to be detected; and a control apparatus, configured to control, according to the first image information, the adjustment mechanism to adjust the probe plate to a detection position, where the first linear direction is parallel to the plane where the probe plate is located.

The battery nickel sheet welding quality detection system in the embodiments of the present application is provided with a detection assembly that is capable of moving along a first linear direction relative to a transverse moving platform, such that when performing detection, the detection assembly may translate many times in the first linear direction, so as to realize the detection of a plurality of sets of battery cells arranged side by side. Therefore, the battery nickel sheet welding quality detection system according to the embodiments of the present application can effectively detect a battery product with a plurality of sets of battery cells arranged side by side, avoiding the need of manually adjusting the position of the battery.

Embodiments of a second aspect of the present application provide a battery nickel sheet welding quality detection method, performed in the battery nickel sheet welding quality detection system described above, the battery nickel sheet welding quality detection method including: controlling the detection assembly to move to a first operating position; acquiring, at the first operating position, third image information of a battery to be detected by using the camera assembly; controlling, according to the third image information, the adjustment mechanism to adjust the probe plate to move to a second operating position by using the control apparatus; and detecting, at the second operating position, the battery to be detected through the at least one probe assembly, where probes of the at least one probe assembly are in contact with a post terminal or a nickel sheet of the battery to be detected at the second operating position.

The above description is only an overview of the technical solutions of the present application. To more clearly understand the technical means of the present application to enable implementation in accordance with the content of the description and to make the above and other purposes, features, and advantages of the present application more obvious and easy to understand, the detailed description of the present application is provided below.

### BRIEF DESCRIPTION OF THE DRAWINGS

In the accompanying drawings, unless otherwise specified, the same reference numerals across multiple accompanying drawings indicate the same or similar components or elements. The accompanying drawings are not necessarily drawn to scale. It should be understood that the accompanying drawings depict only some embodiments of the present application and are therefore not to be considered as limiting the scope of the present application.
FIG. 1 is a schematic diagram of a battery nickel sheet welding quality detection system according to some embodiments of the present application;
FIG. 2 is a schematic diagram of a part of a battery nickel sheet welding quality detection system according to some embodiments of the present application;
FIG. 3 is a schematic diagram of an adjustment mechanism of a battery nickel sheet welding quality detection system according to some embodiments of the present application;
FIG. 4 is a schematic diagram of a probe plate of a battery nickel sheet welding quality detection system according to some embodiments of the present application;
FIG. 5 is a schematic diagram of a probe plate of a battery nickel sheet welding quality detection system according to some embodiments of the present application;
FIG. 6 is a schematic diagram of a probe assembly of a battery nickel sheet welding quality detection system according to some embodiments of the present application;
FIG. 7 is a schematic diagram of a probe assembly of a battery nickel sheet welding quality detection system according to some embodiments of the present application;
FIG. 8 is a flow chart of a battery nickel sheet welding quality detection method according to some embodiments of the present application;
FIG. 9 is a schematic flow chart of a method for adjusting the position of a probe plate according to some embodiments of the present application.

### Description of the reference numerals:

10, battery nickel sheet welding quality detection system; 20, battery product; 30, transport mechanism; 100, transverse moving platform; 110, sliding table; 120, tank chain; 200, detection assembly; 210, support; 220, probe plate; 230, probe assembly; 211, bottom plate; 240, lifting mechanism; 241, lifting plate; 243, guide rod; 244, screw rod; 245, support plate; 250, adjustment mechanism; 251, first translational adjustment part; 2511, first translational plate; 2512, first L-shaped motion block; 252, second translational adjustment part; 2521, second translational plate; 2522, second L-shaped motion block; 2523, second screw rod; 253, rotational adjustment part; 254, probe plate mounting bracket; 2541, side plate; 2542, mounting groove; 2543, opening; 2544, latch; 221, square frame; 222, probe moving mechanism; 223, second plug-in electrical connector; 231, probe base; 232, voltage probe; 233, current probe; 234, first plug-in electrical connector; 235, first electrical contact; 236, probe base mounting hole; 300, camera assembly; 400, automatic spot-checking mechanism; 410, template member; and 420, guide rail.

### DETAILED DESCRIPTION

Embodiments of the technical solutions of the present application will be described in detail below with reference to the drawings. The following embodiments are only for illustrating the technical solutions of the present application more clearly, and therefore are only exemplary and do not limit the protection scope of the present application.

Unless otherwise defined, all technical and scientific terms used herein have the same meaning as commonly understood by those skilled in the technical field to which the present application belongs. The terms used herein are only for illustrating the specific embodiments, rather than limiting the present application. The terms "include", "comprise" and "provided with", and any variations thereof in the specification and claims of the present application and the above-mentioned drawing description encompass non-exclusive inclusions.

In the description of the embodiments of the present application, technical terms such as "first", "second", and the like are only used to distinguish different objects and should not be interpreted as indicating or implying the relative importance or implicitly indicating the number, specific order, or primary and secondary relationship of the indicated technical features. In the description of the embodiments of the present application, unless otherwise specifically defined, "a plurality of" means two or more than two.

Reference in the present application to "embodiment" means that a particular feature, structure, or characteristic described in combination with the embodiment can be included in at least one embodiment of the present application. The references of the word in the context of the specification do not necessarily refer to the same embodiment, nor to separate or alternative embodiments exclusive of other embodiments. It will be explicitly and implicitly appreciated by those skilled in the art that the embodiments described herein can be combined with other embodiments.

In the description of the embodiments of the present application, the term "and/or" is merely a way to describe the associative relationship between associated objects, indicating that there are three possible relationships. For example, "A and/or B" may denote: the presence of A alone, the simultaneous presence of A and B, and the presence of B alone. In addition, the character "/" herein generally indicates an "or" relationship between the associated objects before and after the "/".

In the description of the embodiments of the present application, the term "a plurality of" refers to two or more than two. Similarly, "a plurality of sets" refers to two or more than two sets, and "a plurality of pieces" refers to two or more than two pieces.

In the description of the embodiments of the present application, the technical terms "center", "longitudinal", "transverse", "length", "width", "thickness", "upper", "lower", "front", "rear", "left", "right", "vertical", "horizontal", "top", "bottom", "inner", "outer", "clockwise" "counterclockwise", "axial", "radial", "circumferential" and the like indicating directional or positional relationships are based on the directional or positional relationships shown in the drawings. They are merely for the convenience of describing the embodiments of the present application and simplifying the description, and are not intended to indicate or imply that the apparatuses or elements referred to must have specific directions or must be constructed and operated in specific directions. Therefore, these terms should not be construed as limitations on the embodiments of the present application.

In the description of the embodiments of the present application, unless otherwise clearly specified and defined, the technical terms "mount", "interconnect", "connect", "fix", and the like should be interpreted in their broad senses, and may be, for example, fixed connection, detachable connection, or integrated connection; mechanical connection or electrical connection; or direct connection or indirect connection via an intermediate, or internal communication between two elements or interaction between two elements. For those of ordinary skill in the art, the specific meanings of the above terms in the embodiments of the present application can be interpreted according to the specific condition.

At present, judging from the development of the market situation, the application of power batteries is becoming broader. Power batteries are not only applied in energy storage power systems such as hydropower, thermal power, wind power and solar power stations, but are also widely applied in electric transportation vehicles such as electric bicycles, electric motorcycles, electric cars, as well as in military equipment, aerospace, and other fields. As the application of the power batteries becomes broader, the market demand thereof is also increasing.

As described above, it is an important research topic to improve the production quality of power batteries and to reduce the proportion of defects in power batteries when they leave the factory. Currently, nickel sheets are generally used in power batteries to lead out electrodes in battery cells. Therefore, the welding quality of the nickel sheets of the batteries needs to be detected before the batteries leave the factory, so as to prevent problems such as poor contact. The detection is mainly performed by a battery nickel sheet welding quality detection system, which generally includes a plurality of probe assemblies. Each of the probe assemblies is used for detecting electrical parameters (current, voltage, resistance, etc.) at a specific position of a battery nickel sheet, such that whether the nickel sheet at the position is normally welded can be determined by using the parameters.

In the related art, the welded battery products are transported on a production line via a transport mechanism (e.g., a conveyor belt or other carriers), and the battery products are transported to the position below the battery nickel sheet welding quality detection system to be detected. The battery nickel sheet welding quality detection system includes a lifting mechanism. A probe plate is mounted at the bottom of the lifting mechanism, and a plurality of probe assemblies are mounted at different positions of the probe plate and used for detecting the welding quality of nickel sheets at different positions on a battery product.

The battery nickel sheet welding quality detection system in the related art has the following problems: First, the current battery products are relatively large in size and may include a plurality of sets of cells arranged side by side, but the probe plate has a limited area and cannot cover all the battery cells of the battery. In this case, the battery nickel sheet welding quality detection system cannot detect the electrical parameters of the nickel sheets of all the battery cells at one time. This results in the possibility of subsequent manual adjustment of the position of the battery, which increases the difficulty and complexity of the detection. In addition, in the battery nickel sheet welding quality detection system in the related art, the probe plate is fixedly disposed on the lifting mechanism, and the probe assemblies on the probe plate are also fixedly arranged on the probe plate in advance, such that the probe plate and the probe assemblies of the battery nickel sheet welding quality detection system in the related art are difficult to detach, thereby increasing the difficulty in replacing these parts.

In view of this, the embodiments of the present application provide a novel battery nickel sheet welding quality detection system, which is provided with a detection assembly that is capable of moving along a first linear direction relative to a transverse moving platform, such that when performing detection, the detection assembly may translate many times in the first linear direction, so as to realize the detection of a plurality of sets of battery cells arranged side by side. Therefore, the battery nickel sheet welding quality detection system according to the embodiments of the present application can effectively detect a battery product with a plurality of sets of battery cells arranged side by side, avoiding the need of manually adjusting the position of the battery. Moreover, in the battery nickel sheet welding quality detection system according to the embodiments of the present application, the probe plate is detachably arranged on a support of the detection assembly, and the probe assemblies on the probe plate are also detachably mounted on the probe plate, such that the difficulty in replacing the probe plate or the probe assemblies is reduced.

The system disclosed in the embodiments of the present application can be used for detecting the welding quality of the nickel sheets of the battery, so as to determine whether the battery meets the ex-factory requirements of production quality.

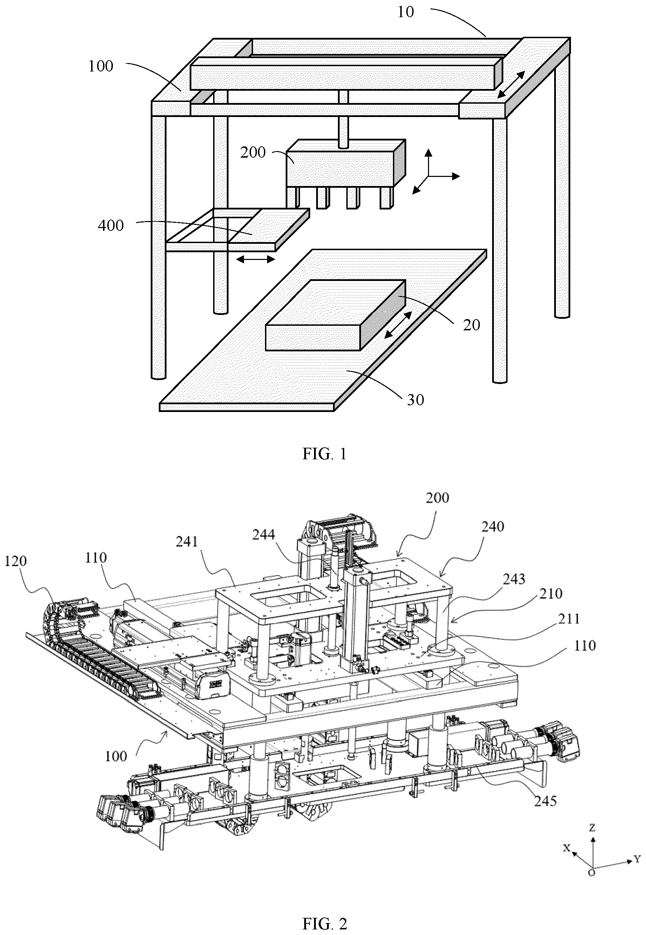

FIG. 1 is a schematic diagram of a battery nickel sheet welding quality detection system according to some embodiments of the present application. As shown in FIG. 1, the operating principle of a battery nickel sheet welding quality detection system 10 is as follows: When a battery product 20 does not reach the position below a detection assembly 200, the detection assembly 200 remains in a lifting-up position; when the battery product 20 reaches the position below the detection assembly 200 (for example, a transport mechanism 30 conveys the battery product 20 to the position below the detection assembly 200, and a battery jacking mechanism further jacks up the battery product 20), the battery nickel sheet welding quality detection system 10 starts detection, the detection assembly 200 may traverse on a transverse moving platform 100, and the detection assembly 200 can further adjust its position on the basis of the position after traverse to reach a pressing-down position, at which probe assemblies on the detection assembly 200 may be in contact with a nickel sheet or a post terminal on the battery product 20 to complete detection of the relevant electrical parameters.

Moreover, the battery nickel sheet welding quality detection system 10 may further include an automatic spot-checking mechanism 400. The automatic spot-checking mechanism 400 will be further described below.

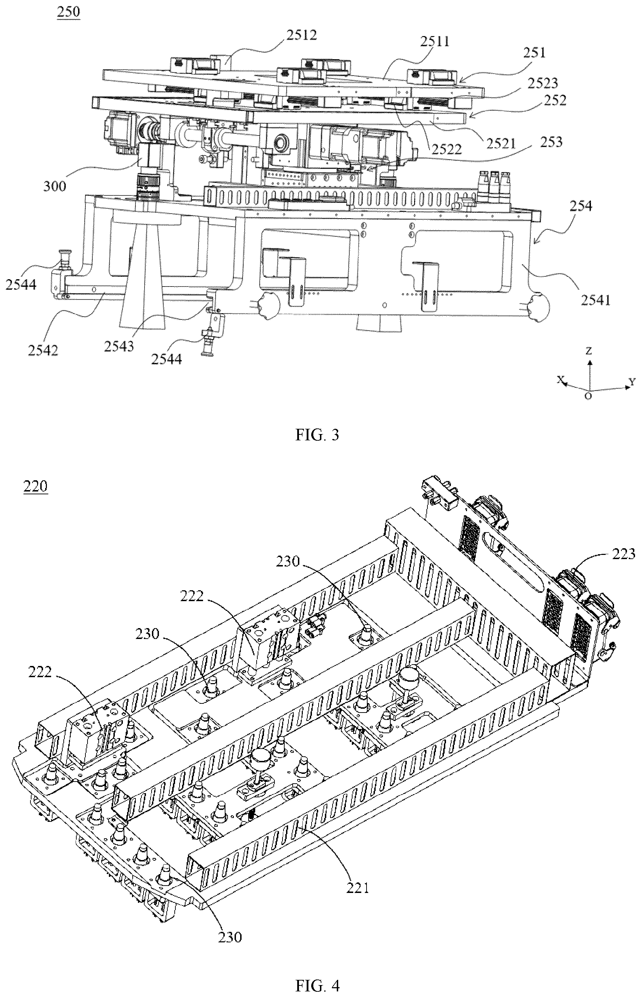

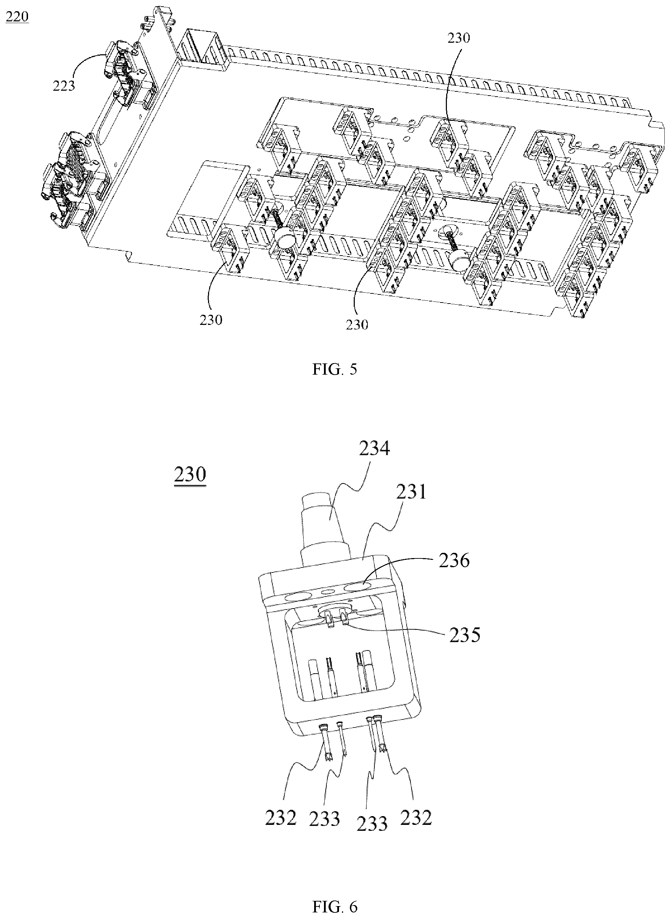

The embodiments of the present application provide a battery nickel sheet welding quality detection system. FIG. 2 is a schematic diagram of a part of a battery nickel sheet welding quality detection system according to some embodiments of the present application; FIG. 3 is a schematic diagram of an adjustment mechanism 250 of a battery nickel sheet welding quality detection system according to some embodiments of the present application; FIG. 4 is a schematic diagram of a probe plate 220 of a battery nickel sheet welding quality detection system according to some embodiments of the present application; FIG. 5 is a schematic diagram of a probe plate 220 of a battery nickel sheet welding quality detection system according to some embodiments of the present application; FIG. 6 is a schematic diagram of a probe assembly 230 of a battery nickel sheet welding quality detection system according to some embodiments of the present application. As shown in FIGs. 2 to 4, the battery nickel sheet welding quality detection system includes: a transverse moving platform 100 and a detection assembly 200. To simplify the drawing, FIG. 2 shows only the transverse moving platform 100 and a part of a support 210 (i.e., a bottom plate 211 and a lifting mechanism 240) of the detection assembly 200, and FIG. 3 shows another part of the support 210 (i.e., an adjustment mechanism 250). In a practical system, the part shown in FIG. 3 is connected below the part of the detection assembly 200 shown in FIG. 2 to form the support 210, and the probe plate 220 shown in FIG. 4 is mounted in the part of the support 210 shown in FIG. 3 to form the entire detection assembly 200. The battery nickel sheet welding quality detection system includes a transverse moving platform 100, a detection assembly 200, a camera assembly 300, and a control apparatus.

The transverse moving platform 100 constitutes a main body portion of the battery nickel sheet welding quality detection system and remains stationary relative to the surrounding environment.

The detection assembly 200 is disposed on the transverse moving platform 100. As described above, the detection assembly 200 at least includes: a support 210, a probe plate 220, at least one probe assembly 230, and an adjustment mechanism (250). The support 210 is capable of moving along a first linear direction (X direction shown in FIG. 2) relative to the transverse moving platform 100. The probe plate 220 is disposed on the support 210 (e.g., can be disposed under the support 210). As shown in FIGs. 4 and 5, each of the probe assemblies 230 is disposed at a corresponding preset position of the probe plate 220 and is configured to be used for detecting relevant electrical parameters at a corresponding position of a battery to be detected. As shown in FIGs. 2 and 3, the support 210 further includes an adjustment mechanism 250. The probe plate 220 is disposed at the bottom end of the adjustment mechanism 250.

The camera assembly 300 is disposed on the adjustment mechanism 250, and the camera assembly 300 is configured to acquire first image information of the battery to be detected.

The control apparatus (not shown in the drawings) is configured to control, according to the first image information, the adjustment mechanism 250 to adjust the probe plate 220 to a detection position (e.g., adjust the position or angle of the probe plate 220 in the plane X, Y, Z to align probes on the probe plate 220 with post terminals or nickel sheets on the battery to be detected).

The first linear direction described above is parallel to the plane where the probe plate 220 is located, that is, the probe plate 220 only moves transversely within the plane where the probe plate is located during the movement of the detection assembly 200.

In an example, a plurality of detection positions may be set in advance in the first linear direction (X direction in the drawings), and the number of the detection positions may be determined according to the number of battery cells of the battery. For example, when the battery product has three sets of battery cells arranged side by side, three detection positions A, B, and C may be set in advance. When detecting a first set of battery cells first, the system may drive the detection assembly 200 to move to the corresponding position A, and at this time, when the probe plate 220 is pressed down, the probe assemblies 230 on the probe plate 220 will be in contact with the nickel sheets on the first set of battery cells, so as to acquire the electrical parameters of the nickel sheets of the first set of battery cells. When detecting a second set of battery cells, the system may drive the detection assembly 200 to move to the corresponding position B, and at this time, when the probe plate 220 is pressed down, the probes on the probe plate 220 will be in contact with the nickel sheets on the second set of battery cells. Similarly, the system may drive the detection assembly 200 to move to the position C to detect the electrical parameters of the nickel sheets of a third set of battery cells. It can be understood that the three sets of battery cells in this example are merely exemplary. In some other examples, the battery may further include two or more than three sets of battery cells, and a corresponding number of detection positions may be set. In some other embodiments, it may not be necessary to preset the detection positions. Instead, the detection positions of the probe plate 220 can be manually adjusted according to the actual distribution of the battery cells in the battery or automatically adjusted by means of image analysis or the like.

As shown in FIG. 3, the camera assembly 300 may include a camera and a light source that provides photographing light for the camera. The camera assembly 300 may be disposed on the adjustment mechanism 250, as shown in FIG. 3. The camera and the light source are both disposed downwards, for capturing images of the sets of battery cells. Images acquired by the camera assembly 300 may be subsequently uploaded to the control apparatus, and the control apparatus performs image analysis to determine a position difference in the horizontal direction between the nickel sheets of the battery cells of the battery to be detected and the detection plate, and further determines, according to the position difference, a position distance (or referred to as a compensation value) that the probe plate 220 needs to be adjusted. The control apparatus sends the compensation value to a lower computer (controller) of the battery nickel sheet welding quality detection system, and the lower computer controls the adjustment mechanism 250 to adjust the position of the probe plate 220 in the plane (i.e., the horizontal direction in the drawings) where the probe plate is located, so as to align the probe plate with the nickel sheets of the battery cells below the probe plate. It will be understood that the camera assembly 300 may include one or a plurality of cameras.

In an example, the process of the image analysis described above is as follows: an x-y coordinate system is established for the probe plate 220, the x-axis thereof is the same as a third linear direction and the y-axis thereof is the same as a fourth linear direction, for subsequent adjustment by the adjustment mechanism 250. The probe plate 220 on the support 210 may be provided with two cameras. First, the two cameras are calibrated in the x-y coordinate system, and a center of rotation is determined. Each of the cameras determines a mark point on the image, and the mark point may be a feature point of the battery (e.g., a geometric feature point such as an edge point or a center point of the battery). First, an offset of a position of a mark point actually found in the captured image in the x-y coordinate system from a position of a pre-calibrated mark point in the field of view of the camera is determined, and adjustment distances required by the probe plate 220 in the third linear direction and the fourth linear direction are determined by determining an x-axis offset and a y-axis offset between the mark points. Two pre-calibrated mark points of the two cameras form a straight line 1, and two mark points in the actual image form a straight line 2. An included angle between the two straight lines may be calculated through the slopes of the two straight lines in the x-y coordinate system, which is an inclined angle of the battery product. The control apparatus determines a rotation angle executed by a rotational adjustment part 253 of the adjustment mechanism 250 according to the inclined angle. During the adjustment process, the rotation operation is performed first, and then the translational adjustment is performed by a first translational adjustment part 251 and a second translational adjustment part 252.

The battery nickel sheet welding quality detection system in the embodiments of the present application is provided with a detection assembly 200 that is capable of moving along a first linear direction relative to a transverse moving platform 100, such that when performing detection, the detection assembly 200 may translate many times in the first linear direction, so as to realize the detection of a plurality of sets of battery cells arranged side by side. Therefore, the battery nickel sheet welding quality detection system according to the embodiments of the present application can effectively detect a battery product with a plurality of sets of battery cells arranged side by side, avoiding the need of manually adjusting the position of the battery.

In addition, by disposing the camera assembly 300 to acquire the image of the battery cells of the battery, the battery nickel sheet welding quality detection system can perform position adjustment on the probe plate 220 according to the analysis result of the image, thereby increasing the precision of the position adjustment.

In some embodiments, the probe plate 220 is detachably disposed on the support 210 to move with the support 210.

As described above, the probe plate 220 is detachably mounted on the portion of the support 210 shown in FIG. 3. The mounting mode includes, but is not limited to, snap-fit mounting, plug-in mounting, threaded mounting, etc. After the mounting is completed, it is necessary to ensure that the probe plate 220 does not sway transversely to avoid inadequate subsequent detection.

In the battery nickel sheet welding quality detection system according to the embodiments of the present application, the probe plate 220 is detachably disposed on the support 210 of the detection assembly 200, such that the difficulty in replacing the probe plate 220 is reduced. In the event of a failure or damage to the probe plate 220, the probe plate 220 may be removed directly from the support 210 and replaced with a new probe plate 220, avoiding replacement of the entire support 210.

The support 210 includes: a bottom plate 211. The bottom plate 211 is configured to be relatively movably connected to the transverse moving platform 100 to drive the support 210 to move. The transverse moving platform 100 includes a first drive mechanism (not shown in the drawings due to occlusion). An output end of the first driving mechanism is connected to the bottom plate 211, for driving the bottom plate 211 to move relative to the transverse moving platform 100.

Further referring to FIG. 2, a set of sliding tables 110 may be fixedly disposed on the transverse moving platform 100. In the embodiment of FIG. 2, there are two sliding tables 110 disposed in parallel and both extending along the X direction. The bottom plate 211 is disposed on the set of sliding tables 110, and can slide bidirectionally along the extending direction of the slide tables 110.

By disposing additional sliding tables 110, it is ensured that the entire detection assembly 200 moves along the extending direction of the sliding tables 110, preventing the detection assembly 200 from being inclined during the movement process.

According to some embodiments of the present application, at least one set of sliding blocks (not shown in the drawings due to occlusion) arranged along the first linear direction are disposed on a surface of the bottom plate 211 on a side, at least one set of sliding rails adapted to the at least one set of sliding blocks are disposed at a relative position of the transverse moving platform 100, and the at least one set of sliding blocks are embedded into the corresponding at least one set of sliding rails, respectively, so as to realize a sliding connection between the bottom plate 211 and the transverse moving platform 100.

As shown in FIG. 2, two sliding rails may be disposed. Each of the sliding rails is disposed on one sliding table 110 and extends in the same direction as the sliding table 110. Correspondingly, two sets of sliding blocks may be disposed. Each of the sets of sliding blocks is disposed on the bottom surface of the bottom plate 211 and can slide in the corresponding sliding rail.

By disposing the sliding rails and the corresponding sliding blocks, it can be ensured that the bottom plate 211 moves stably and smoothly along the X direction on the transverse moving platform 100.

As shown in FIGs. 2 and 3, the support 210 further includes: a lifting mechanism 240 and an adjustment mechanism 250. As described above, the portion of the detection assembly 200 shown in FIG. 2 is the lifting mechanism 240 portion of the support 210, and the adjustment mechanism 250 portion of the support 210 is shown in FIG. 3. The lifting mechanism 240 is capable of being movably disposed on the bottom plate 211 along an upward and downward direction. The upward and downward direction is not parallel to the first linear direction. The adjustment mechanism 250 is disposed below the lifting mechanism 240 (e.g., a component above the adjustment mechanism 250 may be relatively movably connected to a component below the lifting mechanism 240), and the probe plate 220 is detachably disposed at the bottom end of the adjustment mechanism 250.

As shown in FIG. 3, a probe plate mounting bracket 254 is provided at the very bottom of the adjustment mechanism 250 (the adjustment mechanism 250 may also include other components, mainly position adjustment components, which will be described in detail below). The probe plate 220 is detachably disposed at the bottom end of the probe plate mounting bracket 254, such that the probe plate 220 is disposed right below the entire detection assembly 200. When the battery nickel sheet welding quality detection system drives the detection assembly 200 to perform a pressing-down operation, the probe plate 220 moves accordingly and is in contact with the upper surface of the nickel sheets of the battery cells.

The probe plate 220 is detachably mounted at the bottom end of the adjustment mechanism 250, such that the probe plate 220 can be detached and replaced in a timely manner in the case of failure. Meanwhile, corresponding probe plates 220 may be mounted according to different battery products (different probe plates 220 may have probe assemblies 230 with different detection positions) to realize the detection of different battery products.

The bottom end of the adjustment mechanism 250 is provided with a pair of mounting grooves 2542 extending along a second linear direction. The second linear direction is parallel to the plane where the probe plate is located and is perpendicular to the first linear direction. One end of the pair of mounting grooves 2542 described above has openings 2543 to allow the probe plate 220 to be inserted into or separated from the support 210.

As described above, the bottom end of the adjustment mechanism 250 is provided with the probe plate mounting bracket 254, which is provided with left and right vertically disposed side plates 2541. Each of the pair of mounting grooves 2542 described above is disposed on the inner side of the edge of the bottom end of the corresponding side plate 2541, and the pair of mounting grooves 2542 are disposed opposite to each other. The dimensions of the mounting grooves 2542 are adapted to those of the probe plate 220. Specifically, the length of the mounting grooves 2542 should be approximately equal to the length of the probe plate 220 in the direction, the interval between the two mounting grooves 2542 should be approximately equal to the width of the probe plate 220 in the direction, and the width of the openings of the mounting grooves 2542 should be approximately equal to the thickness of the probe plate 220. The dimensional settings described above can ensure that the probe plate 220 is mounted in place.

By providing the mounting grooves 2542, the probe plate 220 may be inserted into the support 210, thereby simplifying mounting and detachment of the probe plate 220.

Further, as shown in FIG. 3, the first linear direction described above may be the X direction, and the second linear direction described above may be the Y direction. That is, the mounting or detachment direction of the probe plate 220 is perpendicular to the direction in which the detection assembly 200 drives the probe plate 220 to translate. This arrangement ensures that the slight sliding of the probe plate 220 in the extending direction (Y direction) of the mounting grooves 2542 does not affect the position of the probe plate 220 in the first linear direction, thereby preventing the probe plate 220 from failing to align with different sets of battery cells of the battery, which may result in inaccurate measurement.

According to some embodiments of the present application, the bottom end of the adjustment mechanism 250 is further provided with at least one latch 2544 separately disposed at each of the openings 2543. The latches 2544 are capable of opening or closing the openings 2543 to allow or prevent the probe plate 220 from being inserted into the support 210.

As shown in FIG. 3, one end of each of the mounting grooves 2542 may be a closed port from which the probe plate 220 cannot be withdrawn; the other end is an opening 2543 provided with the latch 2544 from which the probe plate 220 can be withdrawn when the latch 2544 is open, and from which the probe plate 220 cannot be withdrawn and is fixed in place when the latch 2544 is closed. Specifically, each of the latches 2544 may include a pivotable sealing member and a locking pin disposed at a free end of the sealing member. When the opening 2543 needs to be closed, the sealing member is rotated to close the opening 2543, and meanwhile, the locking pin is inserted into a fixing hole disposed on the edge of the mounting groove 2542 to lock the opening 2543; when the opening 2543 needs to be opened, the locking pin is first pulled out of the fixing hole and the sealing member is then rotated outward to open the opening 2543.

By providing latches 2544, the probe plate 220 can be better fixed to prevent the probe plate 220 from disengaging from the mounting grooves 2542 during the detection process.

In some embodiments, the control apparatus may include: an upper computer, configured to process the first image information to acquire a difference value between the current position and a target position of the adjustment mechanism 250; and a lower computer, configured to control, according to the difference value (or the compensation value), the adjustment mechanism 250 to adjust the probe plate to the target position.

In an example, the upper computer (or the processor) may first determine an offset of a position of a mark point actually found in the captured image in an x-y coordinate system from a position of a pre-calibrated mark point in the field of view of the camera, and determine adjustment distances required by the probe plate 220 in a third linear direction and a fourth linear direction by determining an x-axis offset and a y-axis offset between the mark points. Then, the lower computer (controller) controls, according to the adjustment distances determined by the upper computer, the adjustment mechanism 250 to adjust the probe plate to the target position.

The lifting mechanism 240 includes: a lifting plate 241 and a support plate 245, and a plurality of guide rods 243. The lifting plate 241 and the support plate 245 are disposed above and below the bottom plate 211, respectively, and the adjustment mechanism 250 may be disposed below the support plate 245 (components above the adjustment mechanism 250 may be relatively movably connected to components below the support plate 245). Each of the guide rods 243 passes through the bottom plate 211 and has both ends connected to the lifting plate 241 and the support plate 245, respectively, so as to realize linkage of the lifting plate 241 and the support plate 245. The bottom plate 211 is further provided with a second driving mechanism. An output end of the second driving mechanism is connected to the lifting plate 241, for driving the lifting plate 241 to move up and down relative to the bottom plate 211.

As shown in FIG. 2, the lifting plate 241 and the support plate 245 are both disposed parallel to the bottom plate 211 (i.e., in the X-Y plane in the drawings). Four guide rods 243 may be provided, and are disposed at positions proximal to corners of the lifting plate 241 and the support plate 245, respectively. Openings are formed at corresponding positions on the bottom plate 211 to allow the corresponding guide rods 243 to pass through. Since both ends of each of the guide rods 243 are rigidly connected to the bottom surface of the lifting plate 241 and the top surface of the support plate 245, respectively, the lifting plate 241 and the support plate 245 can move up and down as a whole. The second driving mechanism may be a motor. An output shaft of the motor is a screw rod 244, and a free end of the screw rod 244 is threadedly connected to the lifting plate 241. The screw rod 244 is driven to rotate in a forward or reverse direction during the operation of the motor, and the lifting plate 241 is lifted and lowered through the relative movement between the screw rod 244 and screw threads. The lifting and lowering of the lifting plate 241 will drive the support plate 245 below to lift and lower to the same extent. It can be understood that the arrangements of the motor, the screw rod 244, the threaded connection, and the like in this embodiment is merely illustrative. In some other embodiments, the lifting plate 241 can be moved in other manners. For example, a movable cylinder is used to drive the lifting plate 241 to move.

By disposing a linkage mechanism of the lifting plate 241 and the support plate 245 on the bottom plate 211, the lifting and lowering of the support plate 245 below the bottom plate 211 can be realized. The adjustment mechanism 250 is provided at the bottom of the support plate 245, such that the adjustment mechanism 250 and the probe plate 220 mounted thereon can move up and down with the support plate 245. In the embodiments of the present application, the lifting apparatus including the lifting plate 241 and the support plate 245 can not only move along the first linear direction with the bottom plate 211, but also move up and down relative to the bottom plate 211, which ensures that the detection system can detect a plurality of sets of battery cells of the battery without affecting the normal pressing-down operation of the probe plate 220 during the detection process.

As shown in FIG. 3, according to some embodiments of the present application, the adjustment mechanism 250 is a two-dimensional adjustment mechanism 250. The adjustment mechanism 250 includes: a first translational adjustment part 251, a second translational adjustment part 252, and a rotational adjustment part 253. The first translational adjustment part 251 is configured to adjust the position of the probe plate 220 in a third linear direction in the plane where the probe plate 220 is located; the second translational adjustment part 252 is configured to adjust the position of the probe plate 220 in a fourth linear direction in the plane where the probe plate 220 is located, where the fourth linear direction is orthogonal to the third linear direction. The rotational adjustment part 253 is configured to adjust a rotation angle of the probe plate 220 in the plane where the probe plate 220 is located.

The first translational adjustment part 251 and the second translational adjustment part 252 may have similar components. Specifically, taking the first translational adjustment part 251 as an example, it includes a first translational plate 2511, a first L-shaped motion block 2512, and a first servo motor and a first screw rod (not shown in the drawings for simplicity). The first servo motor and the first screw rod are disposed on the support plate 245 of the lifting mechanism 240, the first screw rod is equipped with the first L-shaped motion block 2512, the first L-shaped motion block 2512 passes through the hollow part of the support plate 245, and the first servo motor drives the first screw rod to rotate, such that the first L-shaped motion block 2512 moves horizontally. A guide rail extending along the third linear direction is mounted at the bottom of the support plate 245 to place the first translational plate 2511, and the first L-shaped motion block 2512 is locked on the top of the first translational plate 2511, thereby realizing the movement of the first translational plate 2511 in the third linear direction. The second translational adjustment part 252 is generally disposed below the first translational adjustment part 251. Similarly, the second translational adjustment part 252 includes a second translational plate 2521, a second L-shaped motion block 2522, and a second servo motor and a second screw rod 2523. A guide rail extending along the fourth linear direction is mounted at the bottom of the first translational plate 2511 to place the second translational plate 2521. The second servo motor and the second screw rod 2523 are disposed at the bottom of the first translational plate 2511, the second screw rod 2523 is equipped with the second L-shaped motion block 2522, the second L-shaped motion block 2522 passes through the hollow part of the second translational plate 2521 and is locked at the bottom of the first translational plate 2511, and the servo motor drives the second screw rod 2523 to rotate, such that the second translational plate 2521 horizontally moves relative to the first translational plate 2511. The rotational adjustment part 253 may include a rotary table and a rotating bearing. The rotary table and the rotating bearing are disposed at the bottom of the second translational plate 2521 and connected to the probe plate mounting bracket 254, and the rotating bearing drives the rotary table to rotate, so as to drive the probe plate 220 to rotate.

By disposing the first translational adjustment part 251, the second translational adjustment part 252, and the rotational adjustment part 253, the free movement of the probe plate 220 in the plane where the probe plate is located can be realized, so as to realize the calibration of the position of the probe plate 220 before the detection of the welding quality of the nickel sheets of the battery.

FIG. 6 illustrates a schematic structural diagram of a probe assembly 230 according to the embodiments of the present disclosure. As shown in FIG. 6, any one of the at least one probe assembly 230 includes: a probe base 231, a plurality of probes, and a first plug-in electrical connector 234. The probe base 231 includes a plurality of probe insertion holes spaced apart from each other. Each of the probes is disposed in a corresponding probe insertion hole, for detecting the relevant electrical parameters. The first plug-in electrical connector 234 is fixed to the probe base 231. One end of the first plug-in electrical connector 234 is provided with a plurality of first electrical contacts 235, each of the plurality of first electrical contacts 235 is electrically connected to a corresponding probe, and the other end of the first plug-in electrical connector 234 is configured to be capable of being plugged into other electrical connectors.

The probe base 231 constitutes a main body portion of the probe assembly 230. A plurality of preset positions on the probe plate 220 may be provided with mounting holes. The mounting of the probe assembly 230 at the position is realized by inserting the probe base 231 into the corresponding mounting hole. As shown in FIG. 6, the first plug-in electrical connector 234 may be an aviation socket. An aviation socket generally has a plastic or metal shell surrounding contacts that are embedded in an insulating material to maintain their alignment. These contacts are generally paired with cables, and the structure of the aviation socket is particularly resistant to environmental interference. In the example shown in FIG. 6, the aviation socket has 4 first electrical contacts 235 that include a pair of voltage contacts and a pair of current contacts. Correspondingly, the plurality of probes include a pair of positive and negative voltage probes 232 and a pair of positive and negative current probes 233. The voltage probes 232 will acquire voltage signals at the position to be detected, and the current probes 233 will acquire current signals at the position to be detected. These probes are disposed on a support member of the aviation socket. During the pressing down process of the probe plate 220, the downward extending tips of the probes will abut against a battery nickel sheet to be detected, causing the probes to retract towards the aviation socket, and the upward end parts of the probes will be in contact with the plurality of first electrical contacts 235 accordingly, so as to transmit electric signals to the aviation socket.

It can be understood that in this embodiment, the probe assembly 230 has 4 probes and is used for detecting voltage and current signals of a nickel sheet. However, in some other embodiments, the probe assembly 230 may have more or less than 4 probes and may detect electric signals other than voltage or current. In addition, in some other embodiments, the probes may also be in contact with the corresponding first contacts in other manners, which is not limited herein.

By providing the probe base 231 capable of being adapted to the probe plate 220, the detachable mounting of the probe assembly 230 on the probe plate 220 is realized, which improves the flexibility of replacing the probe assembly 230. In addition, mounting holes can be disposed at various positions on the probe plate 220, such that the probe assemblies 230 on the probe plate 220 can be adaptively arranged according to the distribution of nickel sheets on the battery product, thereby ensuring that the detection positions on the nickel sheets of the battery are set with pertinence. By disposing the first plug-in electrical connector 234, it is convenient to subsequently collect the electric signals detected by the probes and transmit these signals to an external device.

The first plug-in electrical connector 234 includes a locking component configured to be capable of locking the first plug-in electrical connector 234 to the other electrical connectors when the first plug-in electrical connector 234 is plugged into the other electrical connectors.

The locking component described above may be, for example, a fixing bolt or a snap-fit or plug-in locking mechanism.

By disposing the locking component, the stability of the connection between the first plug-in electrical connector 234 and the other electrical connectors is improved.

The battery nickel sheet welding quality detection system further includes: a second plug-in electrical connector 223. The second plug-in electrical connector 223 is disposed on a side edge of the probe plate 220 on a side, and the first plug-in electrical connector 234 of the probe assembly 230 is electrically connected to the second plug-in electrical connector 223 via a wire.

As shown in FIG. 4, the second plug-in electrical connector 223 is disposed on a side edge of the probe plate 220 on a side in the Y direction in the drawings. The number of the second plug-in electrical connectors 223 may be the same as the number of the first plug-in electrical connectors 234. Each of the second plug-in electrical connectors 223 receives electric signals from the first plug-in electrical connectors 234 via a wire. In some embodiments, the second plug-in electrical connector 223 may be a Harting connector. The second plug-in electrical connector 223 may further transmit the electric signals to other signal receiving devices fixed to the transverse moving platform 100 via a wire, which may be fixed by a tank chain 120 provided on the transverse moving platform 100, as shown in FIG. 2.

By disposing the second plug-in electrical connector 223, it is convenient to export the electric signals acquired from the probe assembly 230.

The probe plate 220 includes at least one probe moving mechanism 222, and at least a part of the at least one probe assembly 230 is mounted on the probe moving mechanisms 222. For example, some of the probe assemblies 230 may be mounted on the corresponding probe moving mechanisms 222 through their probe bases 231. The probe moving mechanism 222 is configured to allow the probe assembly 230 mounted thereon to extend from or retract into the probe plate 220.

As shown in FIG. 4, the probe plate 220 may be of a rectangular frame 221 structure, and a plurality of probe assemblies 230 may be disposed on each edge of the rectangular frame 221. A plurality of probe moving mechanisms 222 are provided across two long edges of the rectangular frame 221. In the example shown in FIG. 4, there are two probe moving mechanisms 222. In some other embodiments, there may be more than two probe moving mechanisms 222. The number of the probe moving mechanisms 222 and the distribution of the probe assemblies 230 thereon can be set according to the distribution of the battery cells on the battery, so as to ensure that the detection range can cover all the nickel sheets. In an example, as shown in FIG. 6, the probe base 231 may be provided with probe base mounting holes 236 (e.g., threaded holes), and the probe moving mechanism 222 may also be provided with mounting holes (e.g., threaded holes). By aligning the mounting holes on the probe base 231 and the probe moving mechanism 222 and fixing them with screws, the probe assembly 230 may be mounted on the probe moving mechanism 222. It will be understood that the fit between the probe base 231 and the probe moving mechanism 222 is not limited to the above manner. For example, the corresponding positions of the probe base 231 and the probe moving mechanism 222 may be provided with snap-fit structures that are mutually fitted, and the rapid mounting and detachment between the probe assembly 230 and the probe moving mechanism 222 may be realized through the snap-fit structures that are mutually fitted.

When detecting a battery with a particular battery cell distribution, at least a part of the plurality of probe moving mechanisms 222 may be selectively extended from the probe plate 220 and the other probe moving mechanisms 222 may be retracted into the probe plate 220. When the probe plate 220 is pressed down for detection, only the probe assemblies 230 on the probe moving mechanisms 222 extending from the probe plate 220 can be in contact with the nickel sheets of the battery cells and acquire electric signals, while the probe assemblies 230 on the retracted probe moving mechanisms 222 does not generate electric signals.

By disposing the probe moving mechanisms 222 and selectively extending or retracting a part of the probe moving mechanisms 222, the detection positions may be adaptively set according to the specific distribution of the nickel sheets of the battery cells of the battery. This can avoid the situation where the position where the nickel sheet is not covered is detected or the position where the nickel sheet is covered is missed, thereby increasing the accuracy of detecting the welding quality of the nickel sheets of the battery.

It will be understood that FIG. 4 shows two probe moving mechanisms 222. However, any number of probe moving mechanisms 222 may be provided. Each of the probe moving mechanisms 222 may be connected to one or a plurality of probe assemblies 230 to allow the one or a plurality of probe assemblies 230 mounted thereon to extend from or retract into the probe plate 220.

In the embodiments of the present disclosure, the probe moving mechanism 222 may be configured to bring probes on the probe assembly 230 into contact with a post terminal or a nickel sheet of a battery to be detected when driving the probe assembly to extend from the probe plate 220.

In an example, when the probe assembly 230 is driven to extend from the probe plate 220, the probe moving mechanism 222 brings one current probe and one voltage probe of four probes on the probe assembly into contact with a post terminal of the battery to be detected, and brings the other current probe and the other voltage probe into contact with a nickel sheet of the battery.

In an example, the probe moving mechanism 222 may include a cylinder. As shown in FIG. 4, one end of a retractable cylinder may be fixed relative to a square frame 221 of the probe plate 220, and the other end of the retractable cylinder is connected to the probe assembly 230 (it can be seen from FIG. 5 that a plurality of the probe assemblies 230 located above are connected to the retractable cylinder in FIG. 4). The cylinder guides a piston to perform a linear reciprocating motion in the cylinder, thereby enabling the probe assembly 230 on the probe moving mechanism 222 to extend from or retract into the probe plate 220.

By disposing the cylinder, the extension or retraction of the probe assembly 230 may be facilitated.

The battery nickel sheet welding quality detection system further includes: a radio frequency identifier (not shown in the drawings), configured to identify identification information associated with the battery to be detected and to send the identification information to the control apparatus. The control apparatus is further configured to control the detection assembly 200 to move along the first linear direction according to a preset strategy corresponding to the identification information.

The radio frequency identifier can realize frequency signal coupling with an electronic tag through a coupling element. In an example, the battery to be detected may be provided with an electronic tag containing identification information, or a carrier carrying the battery to be detected may be provided with an electronic tag containing identification information associated with the battery to be detected. By identifying the identification information associated with the battery to be detected through the radio frequency identifier, the control apparatus may determine the relevant model of the battery to be detected (the battery to be detected of different models may have different arrangements of positions to be detected, e.g., different numbers and intervals of positions to be detected), so as to control the detection assembly 200 to move to an appropriate detection region along the first linear direction according to the preset strategy corresponding to the identification information.

Thus, the welding quality of the nickel sheets of batteries of different models to be detected can be detected.

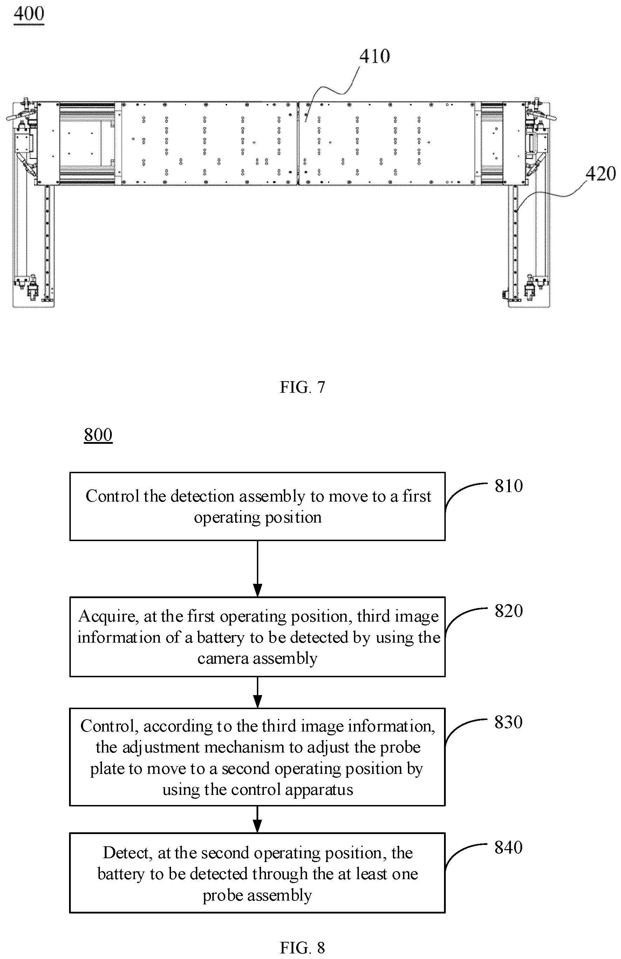

FIG. 7 is a schematic diagram of a probe assembly of a battery nickel sheet welding quality detection system according to some embodiments of the present application. As shown in FIG. 7, the battery nickel sheet welding quality detection system further includes: an automatic spot-checking mechanism 400. The automatic spot-checking mechanism 400 is disposed below the detection assembly 200 (referring to FIG. 1). The automatic spot-checking mechanism 400 includes a template member 410, and the automatic spot-checking mechanism 400 is configured to drive the template member 410 to move from a first position outside the field of view of the camera assembly 300 to a second position within the field of view of the camera assembly 300 before the battery nickel sheet welding quality detection system starts detection. The camera assembly 300 is further configured to acquire second image information of the template member 410 before the start of the detection, for pre-adjustment of the position of the probe plate 220 by the adjustment mechanism 250.

The automatic spot-checking mechanism 400 is a template that simulates the upper surface of a real battery product, such that the camera assembly 300 can pre-adjust the probe plate 220 by acquiring images of the automatic spot-checking mechanism 400 before detecting the real battery product. The second position within the field of view of the camera assembly 300 should coincide with the position of the actual battery product during detection, such that the template member 410 can accurately simulate the real battery product. The automatic spot-checking mechanism 400 may be located at the first position when the battery nickel sheet welding quality detection system is in a non-operational state. Before starting the detection of the battery product, the template member 410 is driven to move to the second position, and at this time, the camera assembly 300 acquires a top image of the template member 410, the lower computer of the battery nickel sheet welding quality detection system uploads the top image to the control apparatus, and the control apparatus performs image analysis on the image to obtain an analysis result. The lower computer pre-adjusts the position of the probe plate 220 after acquiring the analysis result. The image analysis process is similar to the image analysis process mentioned above, and will not be described in detail herein. When the battery product is formally detected, the template member 410 is driven again to move to the first position, so as to avoid affecting the normal detection of the battery product.

By disposing the automatic spot-checking mechanism 400, the position of the probe plate 220 can be pre-adjusted by the battery nickel sheet welding quality detection system, and secondary adjustment can be performed on the basis of the pre-adjustment when the battery product is subsequently formally detected, such that the precision and the adjustment efficiency of the position adjustment of the probe plate 220 are further increased.

Continuing to refer to FIG. 7, the automatic spot-checking mechanism 400 further includes: a set of guide rails 420 and a driving apparatus. The template member is disposed on the set of guide rails 420 and is capable of moving along an extending direction of the set of guide rails 420. An output end of the driving apparatus is connected to the template member 410 and configured to drive the template member 410 to move between the first position and the second position.

The driving apparatus may include a stepping motor. An output end of the stepping motor is connected to the template member 410, and may drive the template member 410 to move bidirectionally along the direction of the guide rails 420.

By providing the guide rails 420 and the driving apparatus, it is convenient for the automatic spot-checking mechanism 400 to move between the first position and the second position described above.

It will be understood that the battery nickel sheet welding quality detection system may further include other components, for example, an electrical cabinet that may be used for providing power supply required for the detection.

According to another aspect of the present disclosure, a battery nickel sheet welding quality detection method is provided. The battery nickel sheet welding quality detection method is performed in the battery nickel sheet welding quality detection system described herein. FIG. 8 is a flow chart of a battery nickel sheet welding quality detection method 800 according to some embodiments of the present application. As shown in FIG. 8, the battery nickel sheet welding quality detection method 800 includes:
step 810, controlling the detection assembly to move to a first operating position;
step 820, acquiring, at the first operating position, third image information of a battery to be detected by using the camera assembly;
step 830, controlling, according to the third image information, the adjustment mechanism to adjust the probe plate to move to a second operating position by using the control apparatus; and
step 840, detecting, at the second operating position, the battery to be detected through the at least one probe assembly, where probes of the at least one probe assembly are in contact with a post terminal or a nickel sheet of the battery to be detected at the second operating position.

In an example, the battery to be detected has a plurality of regions to be detected. For example, the detection assembly can be controlled to move to the first operating position corresponding to a first region to be detected, and then, in step 820 to step 840, the probe plate can be further precisely positioned to the second operating position within the range of the first operating position by the camera and the control apparatus according to the third image information (referring to the process of image analysis described above) captured by the camera, such that the probe assembly is aligned with the position to be detected.

When performing detection, the detection assembly 200 may translate many times in the first linear direction, so as to realize the detection of a plurality of sets of battery cells arranged side by side. Therefore, the battery nickel sheet welding quality detection system according to the embodiments of the present application can effectively detect a battery product with a plurality of sets of battery cells arranged side by side, avoiding the need of manually adjusting the position of the battery.

According to some embodiments, step 820 may include: acquiring an actual position of a first mark point of a battery to be detected; and acquiring an actual position of a second mark point of the battery to be detected. Step 830 may include: determining a first connecting line between the actual position of the first mark point and the actual position of the second mark point; and controlling, according to the first connecting line and a second connecting line, the adjustment mechanism to adjust the probe plate to the second operating position, where the second connecting line is a connecting line between a preset position of the first mark point and a preset position of the second mark point, and in the second operating position, an included angle between the first connecting line and the second connecting line is smaller than a preset angle. In an example, first, two cameras may be calibrated in an x-y coordinate system, and a center of rotation may be determined. Each of the cameras determines a mark point on the image, and the mark point may be a feature point of the battery (e.g., a geometric feature point such as an edge point or a center point of the battery). First, an offset of a position of a mark point actually found in the captured image in the x-y coordinate system from a position of a pre-calibrated mark point in the field of view of the camera is determined, and adjustment distances required by the probe plate 220 in a third linear direction and a fourth linear direction are determined by determining an x-axis offset and a y-axis offset between the mark points. Two pre-calibrated mark points of the two cameras form a straight line 1, and two mark points in the actual image form a straight line 2. An included angle between the two straight lines may be calculated through the slopes of the two straight lines in the x-y coordinate system, which is an inclined angle of the battery product. The control apparatus determines a rotation angle executed by a rotational adjustment part 253 of the adjustment mechanism 250 according to the inclined angle.

Thus, the precision of the position adjustment of the probe plate can be increased.

According to some embodiments, the battery nickel sheet welding quality detection system may further include a radio frequency identifier, and the battery nickel sheet welding quality detection method 800 may further include:
identifying identification information associated with the battery to be detected by using the radio frequency identifier before controlling the detection assembly to move to the first operating position;
sending the identification information to the control apparatus through the radio frequency identifier; and
the control apparatus controlling the detection assembly to move to the first operating position according to a preset strategy corresponding to the identification information.

By identifying the identification information associated with the battery to be detected through the radio frequency identifier, the control apparatus may determine the relevant model of the current battery to be detected, so as to control the detection assembly to move to the first operating position specified in a preset strategy corresponding to the identification information along the first linear direction according to the preset strategy.

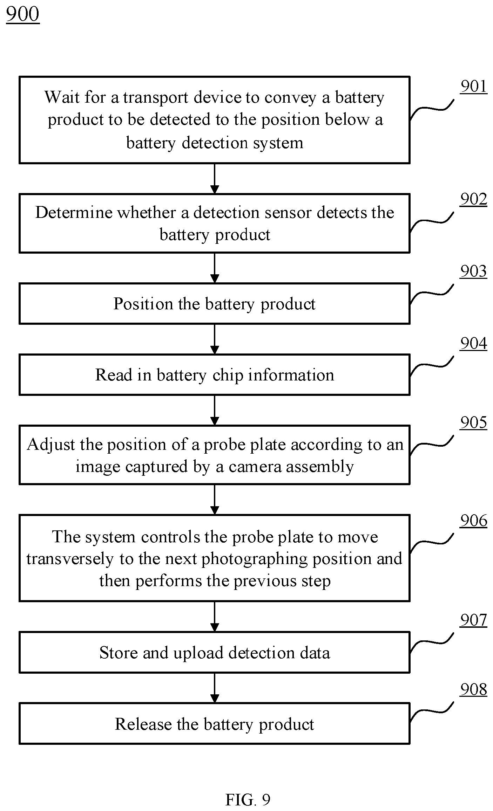

How to adjust the probe plate 220 assembly before detecting the battery will be described in detail below with reference to FIG. 9. FIG. 9 shows a flow chart of a method 900 for adjusting the position of a probe plate 220 according to the embodiments of the present disclosure. As shown in FIG. 9, the method 900 includes:
step 901, waiting for a transport device to convey a battery product to be detected to the position below a battery nickel sheet welding quality detection system;
step 902, determine whether a detection sensor detects the battery product;
step 903, if the determination result of step 902 is yes, positioning the battery product;
step 904, reading in battery chip information;
step 905, adjusting the position of a probe plate 220 according to an image captured by a camera assembly 300;
step 906, after detection at the current point is completed, the system controlling the probe plate 220 to move transversely to the next photographing position, and then performing the previous step;
step 907, storing and uploading detection data; and
step 908, releasing the battery product.

As described above, before step 901 is performed, the position of the probe plate 220 may be pre-adjusted by the automatic spot-checking mechanism 400, and the pre-adjustment method is similar to the above adjustment method during the actual detection process, and will not be described in detail herein. In step 901, a relevant upper computer (processor) of the transport device receives a signal allowing the battery product to be detected to enter, and waits for the transport device to convey the battery product to be detected to the position below the battery nickel sheet welding quality detection system. The transport device may be, for example, a conveyor belt.

The battery nickel sheet welding quality detection system is further provided with a variety of sensors and optical gratings for sensing the battery product therebelow and relevant attributes of the battery product. In step 902, the sensor may detect whether the carrier carrying the battery is in place. When the carrier is determined to be in place, the grating detection is initiated. The relevant detection sensor further detects whether there is a battery product, if there is, the battery product is determined to be in place, and if no battery product is sensed, the carrier can be released directly.

In step 903, a jacking cylinder is lifted, a positioning pin extends into a fixture pin hole for primary positioning, a jacking in-place sensor senses a signal, and a through-beam sensor senses whether the product is inclined.

The battery nickel sheet welding quality detection system may further include a radio frequency identifier. In step 904, the radio frequency identifier identifies battery chip information in the carrier, the lower computer (controller) of the battery nickel sheet welding quality detection system transmits the acquired product identity information to the control apparatus, and the control apparatus further uploads the product identity information to a manufacturing execution system to acquire other data of the product, such as model number, so as to determine the subsequent detection solution of the battery nickel sheet welding quality detection system. Illustratively, the battery chip information may be displayed on the battery product in a two-dimensional code manner, and the control apparatus determines the information such as the model of the battery by identifying the two-dimensional code and transmits the information to the controller of the battery nickel sheet welding quality detection system. A plurality of detection solutions may be pre-stored in the controller, and the detection solutions may include the calibration position of the probe plate 220, the number and distribution of the probe assemblies 230 on the probe plate 220, etc. The detection solutions are each used for the detection of different battery products. The controller may select an appropriate detection solution according to the model of the battery based on the information acquired from the control apparatus.

In step 905, a first set of battery cells to be detected in the battery product is first determined, and the detection assembly 200 is allowed to move transversely to the position along the first linear direction. Subsequently, the lifting mechanism 240 drives the probe plate 220 to press down until a photographing position is reached, and at this time, the camera assembly 300 captures an image, and transmits the image to the processor of the control apparatus. Then, the movement of the probe plate 220 is controlled based on the compensation value obtained by the control apparatus. After the probe plate 220 is in place, the lifting mechanism 240 presses down again until a detection position is reached, and at this time, the probe assembly 230 is in contact with the nickel sheets on the battery cells. The controller of the system controls the detection circuits to be conducted in sequence and informs the control apparatus to execute detection.

In step 906, after the detection at the current position is completed, the lifting mechanism 240 is lifted, and the system controls the probe plate 220 to move transversely to the position where the next set of battery cells is located, and repeats step 905, that is, adjusts the position of the probe plate 220 according to the image.

In step 907, after all the sets of battery cells are detected, the lifting mechanism 240 is lifted, and the detection data is saved and uploaded to the manufacturing execution system.

The various steps described above with respect to method 900 may be implemented in hardware or in hardware in combination with software and/or firmware. For example, these steps may be implemented as computer program code/instructions configured to be executed in one or a plurality of processors and stored in a computer-readable storage medium. Alternatively, these steps may be implemented by hardware logic/circuit. The hardware logic/circuit may include integrated circuit chips (including one or a plurality of components of a processor (e.g., a central processing unit (CPU), a microcontroller, a microprocessor, a digital signal processor (DSP), etc.), a memory, one or a plurality of communication interfaces, and/or other circuits) and may optionally execute the received program code and/or include embedded firmware to perform functions.

Finally, it should be noted that the above embodiments are only used to illustrate the technical solutions of the present application, but not to limit them. Although the present application has been described in detail with reference to the foregoing embodiments, those of ordinary skill in the art should understand that they can still modify the technical solutions recorded in the foregoing embodiments or make equivalent substitutions for some or all of the technical features; however, these modifications or substitutions do not make the essence of the corresponding technical solutions deviate from the spirit and scope of the technical solutions in the embodiments of the present application, and these modifications or substitutions shall all fall within the scope of claims and description of the present application. In particular, the technical features mentioned in the embodiments may be combined in any manner as long as there are no structural conflicts. The present application is not limited to the specific embodiments disclosed herein, but encompasses all technical solutions falling within the scope of the claims.

## Claims

1. A battery nickel sheet welding quality detection system, comprising:
a transverse moving platform (100); and
a detection assembly (200), comprising:
a support (210), capable of being movably disposed on the transverse moving platform along a first linear direction relative to the transverse moving platform;
a probe plate (220), disposed on the support;
at least one probe assembly (230), each probe assembly disposed at a corresponding preset position of the probe plate and configured to detect relevant electrical parameters at a corresponding position of a battery to be detected, wherein any one of the at least one probe assembly (230) comprises:
a probe base (231), comprising a plurality of probe insertion holes spaced apart from each other;
a plurality of probes, each of the probes being disposed in a corresponding probe insertion hole, for detecting the relevant electrical parameters; and
a first plug-in electrical connector (234), the first plug-in electrical connector (234) being fixed to the probe base (231), wherein one end of the first plug-in electrical connector (234) is provided with a plurality of first electrical contacts (235), each of the plurality of first electrical contacts (235) being electrically connected to a corresponding probe, and the other end of the first plug-in electrical connector (234) is configured to be capable of mating with another electrical connector; and
an adjustment mechanism (250), disposed on the support, the probe plate (220) being disposed at the bottom end of the adjustment mechanism;
a camera assembly (300), disposed on the adjustment mechanism (250) and configured to acquire first image information of the battery to be detected; and
a control apparatus, configured to control the adjustment mechanism (250) to adjust the probe plate to a detection position according to the first image information,
wherein the first linear direction is parallel to the plane where the probe plate is located.

2. The battery nickel sheet welding quality detection system according to claim 1, wherein the probe plate (220) is detachably disposed on the support (210) to move with the support.

3. The battery nickel sheet welding quality detection system according to claim 2, wherein the support (210) comprises:
a bottom plate (211), configured to be relatively movably connected to the transverse moving platform (100) to drive the support (210) to move, wherein
the transverse moving platform (100) comprises a first driving mechanism, an output end of the first driving mechanism being connected to the bottom plate (211), for driving the bottom plate to move relative to the transverse moving platform (100).

4. The battery nickel sheet welding quality detection system according to claim 3, wherein
at least one set of sliding blocks arranged along the first linear direction are disposed on a surface of the bottom plate (211) on a side, at least one set of sliding rails adapted to the at least one set of sliding blocks are disposed on the transverse moving platform (100) at a corresponding position, and the at least one set of sliding blocks are embedded into the corresponding at least one set of sliding rails, respectively, so as to realize a sliding connection between the bottom plate and the transverse moving platform.

5. The battery nickel sheet welding quality detection system according to claim 4, wherein the support (210) further comprises:
a lifting mechanism (240), the lifting mechanism (240) being capable of being movably disposed on the bottom plate (211) along an upward and downward direction, and the upward and downward direction being not parallel to the first linear direction, and wherein
the adjustment mechanism (250) is disposed below the lifting mechanism (240), and the probe plate (220) is detachably disposed at the bottom end of the adjustment mechanism (250).

6. The battery nickel sheet welding quality detection system according to claim 5, wherein
the bottom end of the adjustment mechanism (250) is provided with a pair of mounting grooves (2542) extending along a second linear direction, wherein the second linear direction is parallel to the plane where the probe plate is located and is perpendicular to the first linear direction;
one end of the pair of mounting grooves (2542) has openings (2543) to allow the probe plate (220) to be inserted into or separated from the support (210).

7. The battery nickel sheet welding quality detection system according to claim 6, wherein
the bottom end of the adjustment mechanism (250) is further provided with at least one latch (2544) separately disposed at each of the openings (2543), the latches (2544) being capable of opening or closing the openings (2543) to allow or prevent the probe plate (220) from being inserted into the support (210).

8. The battery nickel sheet welding quality detection system according to any one of claims 1 to 7, wherein the control apparatus comprises:
an upper computer, configured to process the first image information to acquire a difference value between the current position and a target position of the adjustment mechanism (250); and
a lower computer, configured to control the adjustment mechanism (250) to adjust the probe plate to the target position according to the difference value.

9. The battery nickel sheet welding quality detection system according to claim 5, wherein the lifting mechanism (240) comprises:
a lifting plate (241) and a support plate (245), respectively disposed above and below the bottom plate (211), the adjustment mechanism (250) being disposed below the support plate (245); and
a plurality of guide rods (243), each of the guide rods passing through the bottom plate (211) and having both ends respectively connected to the lifting plate (241) and the support plate (245), so as to enable the lifting plate and the support plate to move in a linked manner, and
wherein the bottom plate (211) is further provided with a second driving mechanism, an output end of the second driving mechanism being connected to the lifting plate (241), for driving the lifting plate to move up and down relative to the bottom plate.

10. The battery nickel sheet welding quality detection system according to any one of claims 1 to 9, wherein the adjustment mechanism (250) comprises:
a first translational adjustment part (251), configured to adjust a position of the probe plate (220) in a third linear direction in the plane where the probe plate is located;
a second translational adjustment part (252), configured to adjust a position of the probe plate (220) in a fourth linear direction in the plane where the probe plate is located, wherein the fourth linear direction is orthogonal to the third linear direction; and
a rotational adjustment part (253), configured to adjust a rotation angle of the probe plate (220) in the plane where the probe plate is located.

11. The battery nickel sheet welding quality detection system according to any one of claims 1 to 10, wherein the first plug-in electrical connector (234) comprises a locking component configured to be capable of locking the first plug-in electrical connector (234) to the other electrical connector when the first plug-in electrical connector (234) is mated with the other electrical connector.

12. The battery nickel sheet welding quality detection system according to any one of claims 1 to 11, further comprising:
a second plug-in electrical connector (223), the second plug-in electrical connector (223) being disposed on a side edge of the probe plate (220) on a side, and the first plug-in electrical connector (234) of the probe assembly (230) being electrically connected to the second plug-in electrical connector (223) via a wire.

13. The battery nickel sheet welding quality detection system according to any one of claims 1 to 12, wherein the probe plate (220) comprises a probe moving mechanism (222), and at least a part of the at least one probe assembly (230) is mounted on the probe moving mechanism (222), the probe moving mechanism (222) being configured to allow the probe assembly (230) mounted thereon to extend from or retract into the probe plate (220).

14. The battery nickel sheet welding quality detection system according to claim 13, wherein the probe moving mechanism (222) is configured to bring probes on the probe assembly into contact with a post terminal or a nickel sheet of the battery to be detected when driving the probe assembly (230) to extend from the probe plate (220).

15. The battery nickel sheet welding quality detection system according to any one of claims 1-14, further comprising:
a radio frequency identifier, configured to identify identification information associated with the battery to be detected and to send the identification information to the control apparatus, wherein the control apparatus is further configured to control the detection assembly to move along the first linear direction according to a preset strategy corresponding to the identification information.

16. The battery nickel sheet welding quality detection system according to any one of claims 1-15, further comprising:
an automatic spot-checking mechanism (400), disposed below the detection assembly (200), the automatic spot-checking mechanism (400) comprising a template member (410), the automatic spot-checking mechanism (400) being configured to drive the template member (410) to move from a first position outside the field of view of the camera assembly (300) to a second position within the field of view of the camera assembly (300) before the battery nickel sheet welding quality detection system starts detection, wherein
the camera assembly (300) is further configured to acquire second image information of the template member (410) before the start of detection, for pre-adjustment of the position of the probe plate (220) by the adjustment mechanism (250).

17. The battery nickel sheet welding quality detection system according to claim 16, wherein the automatic spot-checking mechanism (400) further comprises:
a set of guide rails (420), the template member (410) being disposed on the set of guide rails (420) and being capable of moving along an extending direction of the set of guide rails (420); and
a driving apparatus, an output end of the driving apparatus being connected to the template member (410) and configured to drive the template member (410) to move between the first position and the second position.

18. A battery nickel sheet welding quality detection method, performed in the battery nickel sheet welding quality detection system according to any one of claims 1 to 17, the battery nickel sheet welding quality detection method comprising:
controlling the detection assembly to move to a first operating position;
acquiring, at the first operating position, third image information of a battery to be detected using the camera assembly;
controlling, according to the third image information, the adjustment mechanism to adjust the probe plate to move to a second operating position using the control apparatus; and
detecting, at the second operating position, the battery to be detected through the at least one probe assembly, wherein probes of the at least one probe assembly are in contact with a post terminal or a nickel sheet of the battery to be detected at the second operating position.

19. The battery nickel sheet welding quality detection method according to claim 18, wherein acquiring the third image information of the battery to be detected using the camera assembly comprises:
acquiring an actual position of a first mark point of the battery to be detected; and
acquiring an actual position of a second mark point of the battery to be detected, and
wherein controlling, according to the third image information, the adjustment mechanism to adjust the probe plate to move to the second operating position comprises:
determining a first connecting line between the actual position of the first mark point and the actual position of the second mark point; and
controlling, according to the first connecting line and a second connecting line, the adjustment mechanism to adjust the probe plate to the second operating position, wherein the second connecting line is a connecting line between a preset position of the first mark point and a preset position of the second mark point, and in the second operating position, an included angle between the first connecting line and the second connecting line is smaller than a preset angle.

20. The battery nickel sheet welding quality detection method according to claim 18 or 19, wherein the battery nickel sheet welding quality detection system further comprises a radio frequency identifier, and the battery nickel sheet welding quality detection method further comprises:
identifying identification information associated with the battery to be detected using the radio frequency identifier before controlling the detection assembly to move to the first operating position;
sending the identification information to the control apparatus through the radio frequency identifier; and
controlling, by the control apparatus, the detection assembly to move to the first operating position according to a preset strategy corresponding to the identification information.
